# EUROPEAN PATENT APPLICATION

(11) **EP 4 766 111 A1**
(43) Date of publication of application: **24.06.2026**
(21) Application number: 24307219.6
(22) Date of filing: 20.12.2024
(51) Int. Cl.: H10K 30/50, H10K 85/50

(54) **ORGANO HALIDE MACROCYCLES AS ADDUCTS FOR HYBRID ORGANIC INORGANIC PEROVSKITE (HOIPS) WTH IMPROVED ENVIRONMENTAL STABILITY**

(71) Applicant: Centre National de la Recherche Scientifique, 75016 Paris (FR); UNIVERSITE DE MONTPELLIER, 34090 Montpellier (FR); Ecole Nationale Supérieure de Chimie de Montpellier, 34090 Montpellier (FR)
(72) Inventor: VOIRY, Damien, 34000 Montpellier (FR); BENKHALED, Belkacem Tarek, 34090 Montpellier (FR); JADHAV, Rohitkumar, 34090 Montpellier (FR); CHAIX, Arnaud, 34090 Montpellier (FR); SEMSARILAR, Mona, 34080 Montpellier (FR)
(74) Representative: Novagraaf Technologies

(57) **Abstract**

The present invention belongs to the field of renewable energy and green energy production, and in particular to the field of solar cells.

The present invention relates to a new versatile family of perovskite, perovskite based solar cells, and in particular to a perovskite comprising a trianglamine salt, the use of a trianglamine salt as an adduct in a perovskite. The invention also relates to the process of synthesis of a perovskite according to the invention and the use of said perovskite in energy production devices.

## Description

### Technical field

The present invention belongs to the field of renewable energy and green energy production, and in particular to the field of solar cells.

The present invention relates to new versatile family of perovskite, perovskite based solar cells, and in particular to a perovskite comprising a trianglamine salt, the use of a trianglamine salt as an adduct in a perovskite. The invention also relates to the process of synthesis of a perovskite according to the invention and the use of said perovskite in energy production devices.

### Technical background

The global consumption of fossil fuels has massive environmental ramifications and is unsustainable in the long term. The cheaper and rapid transition towards the green energy production is essential for smooth transition. Perovskite solar cells have garnered significant attention due to their potential to revolutionize the renewable energy landscape. One of the most notable advantages of perovskite solar cells is their exceptional Photoconversion efficiencies (PCE). Among them, FAPbI₃ has emerged as promising member of Hybrid perovskite material family with excellent PCE, but it suffers from oxygen, moisture, thermal and photo stability issues.

The current challenge in the HOIP solar cells resides in its poor stability against oxygen, moisture, heat and light. The instabilities rose due to intrinsic and extrinsic defect formation in the bulk perovskite layer. Several strategies have been employed to improve the stability against different stressors, but a multi defect passivating agent is still to be found.

Formamidinium based HOIPs (FAPI) is one of the most promising compositions of HOIPs but its use is limited because of its intrinsic high instability against moisture, temperature and light. Several reports of stable FAPbl3 mention addition of the MACI or Csl adduct to improve the stability, but when studied under harsh condition these perovskite Solar cells degrade under 85% static humidity and continuous 1.5 AG illumination. The main cause of the degradation of MACI added FAPbl3 is the volatile MA cation. Methylammonium surely helps in stabilizing the α-FAPbI3 phase, but under stressor like, moisture, oxygen, Heat and light the MA cation starts evaporating and creates cationic defects, these cationic defects help Iodide defects to migrate, and the self-degradation mechanism takes down the perovskite structure. Another strategy to improve stability of FAPbI₃ is to use Csl as an adduct to enhance the temperature stability of the α-FAPbI3 phase. Addition of the Cs cation surely enhances the temperature stability of encapsulated devices but over longer exposure of light and heat together the formamedinum cation starts leaving the perovskite structure creating cationic defects, on another side the unreacted PbI2 undergoes photo degradation forming more Pb0 defects. The formation of metallic lead also triggers iodide self-degradation cycles.

To solve all issues there is an urgent need of a defect passivating agent which can bind to Pb²⁺, I⁻ and FA⁺ related defects.

### Definitions

As used herein other than the claims, the terms "a," "an," "the," and/or "said" means one or more. As used herein in the claim(s), when used in conjunction with the words "comprise," "comprises" and/or "comprising," the words "a," "an," "the," and/or "said" may mean one or more than one. As used herein and in the claims, the terms "having," "has," "is," "have," "including," "includes," and/or "include" has the same meaning as "comprising," "comprises," and "comprise." As used herein and in the claims "another" may mean at least a second or more. As used herein and in the claims, "about" refers to any inherent measurement error or a rounding of digits for a value (e.g., a measured value, calculated value such as a ratio), and thus the term "about" may be used with any value and/or range.

The phrase "a combination thereof" "a mixture thereof' and such like following a listing, the use of "and/or" as part of a listing, a listing in a table, the use of "etc" as part of a listing, the phrase "such as," and/or a listing within brackets with "e.g.," or i.e., refers to any combination (e.g., any subset) of a set of listed components, and combinations and/or mixtures of related species and/or embodiments described herein though not directly placed in such a listing are also contemplated. Such related and/or like genera(s), sub-genera(s), specie(s), and/or embodiment(s) described herein are contemplated both in the form of an individual component that may be claimed, as well as a mixture and/or a combination that may be described in the claims as "at least one selected from," "a mixture thereof" and/or "a combination thereof."

In general, the term "substituted" whether preceded by the term "optionally" or not, and substituents contained in formulae of this invention, refer to the replacement of hydrogen radicals in a given structure with the radical of a specified substituent. When more than one position in any given structure may be substituted with more than one substituent selected from a specified group, the substituent may be either the same or different at every position. As used herein, the term "substituted" is contemplated to include all permissible substituents of organic compounds.

As used herein, the "heteroatom" means a different from carbon or hydrogen. Heteroatoms are preferably chosen from nitrogen, oxygen, and silicon.

As used herein, the term "alkyl", refers to straight and branched alkyl groups. An analogous convention applies to other generic terms such as "alkenyl", "alkynyl" and the like. In certain embodiments, as used herein, "lower alkyl" is used to indicate those alkyl groups (substituted, unsubstituted, branched or unbranched) having about 1-6 carbon atoms. Illustrative alkyl groups include, but are not limited to, for example, methyl, ethyl, n-propyl, isopropyl, allyl, n-butyl, sec-butyl, isobutyl, tert-butyl, n-pentyl, sec-pentyl, isopentyl, tert-pentyl, n-hexyl, sec-hexyl, moieties and the like, which again, may bear one or more substituents. Alkenyl groups include, but are not limited to, for example, ethenyl, propenyl, butenyl, 1-methyl-2-buten-l-yl, and the like. Representative alkynyl groups include, but are not limited to, ethynyl, 2-propynyl (propargy1), 1-propynyl and the like.

In general, the term "aromatic moiety" or "aryl", as used herein, refers to stable substituted or unsubstituted unsaturated mono- or polycyclic hydrocarbon moieties having preferably 3-14 carbon atoms, comprising at least one ring satisfying the Hackle rule for aromaticity. Examples of aromatic moieties include, but are not limited to, phenyl, indanyl, indenyl, naphthyl, phenanthryl and anthracyl. As used herein, the term "heteroaryl" refers to an aryl having at least one aromatic carbon atom in the ring structure replaced by a heteroatom.

The term "halogen" as used herein refers to an atom selected from fluorine, chlorine, bromine and iodine. "halo group" refers to a halogen substituent such as -F, -Br, -Cl or -I. The term "halogen ion" as used herein refers to Br, Cl⁻ and I⁻.

The term "molecular anion" as used herein refers to polyatomic ion which is formed in radical anion by a covalent bond by sharing more than one electron. For example, BF₄⁻ is a molecular anion.

As used herein, the term "independently" refers to the fact that the substituents, atoms or moieties to which these terms refer, are selected from the list of variables independently from each other (i.e., they may be identical or the same).

As used herein, the term "and/or" means any one of the items, any combination of the items, or all of the items with which this term is associated.

### Detailed description of the invention

The inventors of the present invention found out that trianglamine iodide (TAI), along with other halogenated salts, such as bromide (TABr), chloride (TACl) and tetrafluoroborate (TABF₄), of trianglamine (TA) has ability to passivate all the previously mentioned defects. Trianglamine iodide is obtained from the halogenation of pristine trianglamine, which has previously been identified to strongly interact with iodine.

The halide salts amine macrocycles including trianglamine iodide, trianglamine bromide, trianglamine chloride and trianglamine tetrafluroborate as an excellent adducts for hybrid organic inorganic perovskite (HOIPs) FAMAPbI₃ and FACsPbI₃ as well as and full inorganic perovskite (FIPs) semiconductors. These adducts not only improve the stability of the perovskite semiconductor but also improves the crystallinity, passivates the bulk defects like Pb⁰, Pb²⁺,I⁻ and FA⁺ defects improving the charge carrier lifetime. The improvement in the charge carrier lifetime indicates less non-radiative losses which improves the Voc of the photovoltaic devices.

The invention thus also relates to the use of organohalide molecules as adducts to improve the opto-electronic performance and the properties of HOIPs and FIPs for applications in photovoltaics, photodetectors, LEDs, X-ray detection, transistors and other optoelectronic devices.

The Applicant has developed a new TAX*-containing perovskite, wherein X⁻ is a halogen ion or a molecular anion, that may be chosen from Br, Cl⁻, I⁻ or BF₄⁻, able to passivate all the previously mentioned defects.

These materials have strong potential in optoelectronics, photovoltaics, semiconductors, X-ray detectors.

Perovskite films containing trianglamine show improved optical properties, as evidenced by increased PL. The films were characterized using X-ray diffraction (XRD) and AFM with improved crystallinity and a smoother surface suggesting an improved interface in final optoelectronic devices. High crystallinity, smoothness and enhanced emission means less defects with respect to control films. To test the stability both control and target films were exposed to 85% absolute static humidity, while continuously recording the XRD pattern and PL response.

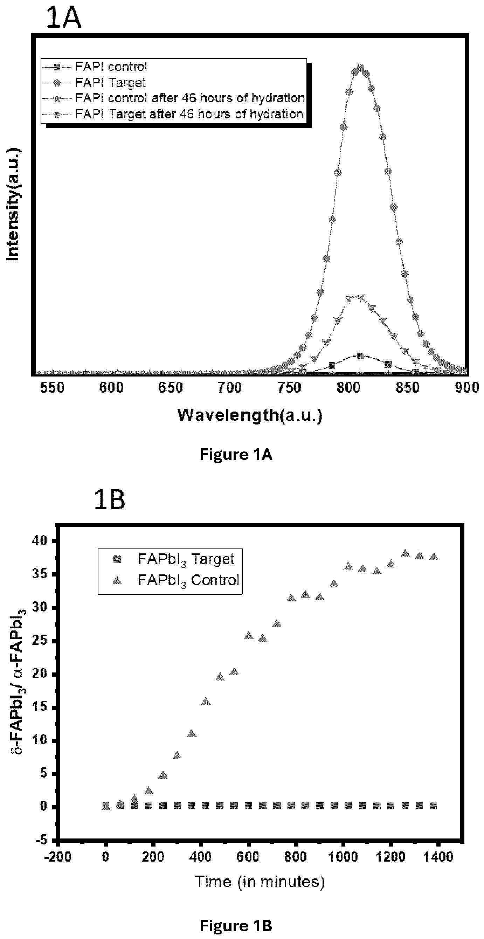

It was found that the photoluminescence intensity of the TAX-containing perovskites was still higher than PL intensity of control Perovskite after extreme hydration under 85% static humidity in Figure 1(a). The in-situ X-ray diffraction also showed the evolution of δ-FAPbI3 phase with respect to α-FAPbI3 phase in Figure 1(b). The δ-FAPbI3 is the is hexagonal phase of perovskite which is optoelectronically inactive. High-temperature stability remains one of the most significant challenges hindering the commercialization of perovskite solar cell technology, among various other stressors.

A first object of the invention is a perovskite comprising a halogen or molecular anion salt of the trianglamine (TA) compound of formula I: 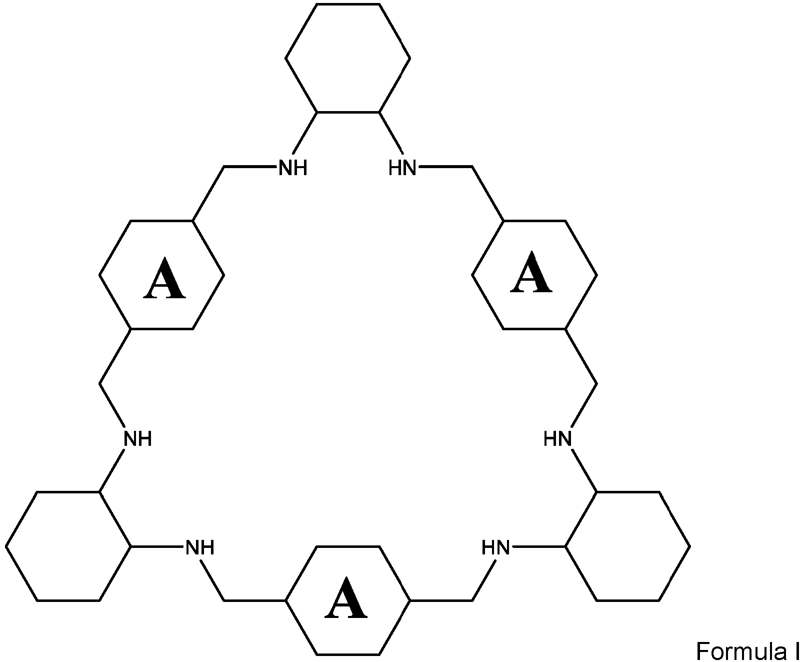 wherein,
- each A independently represents a substituted or unsubstituted 4 to 18-membered aryl or heteroaryl link. Preferably, the halogen or molecular anion salt of the trianglamine (TA) may be (TAX*), wherein
   X* = Xₙ+X⁻ₙ₋₁ wherein n ≤ 6 and X is chosen from Br, Cl, I or BF₄.

Advantageously, the perovskite according to the invention may be a perovskite comprising a trianglamine halogen or molecular anion salt of formula II: 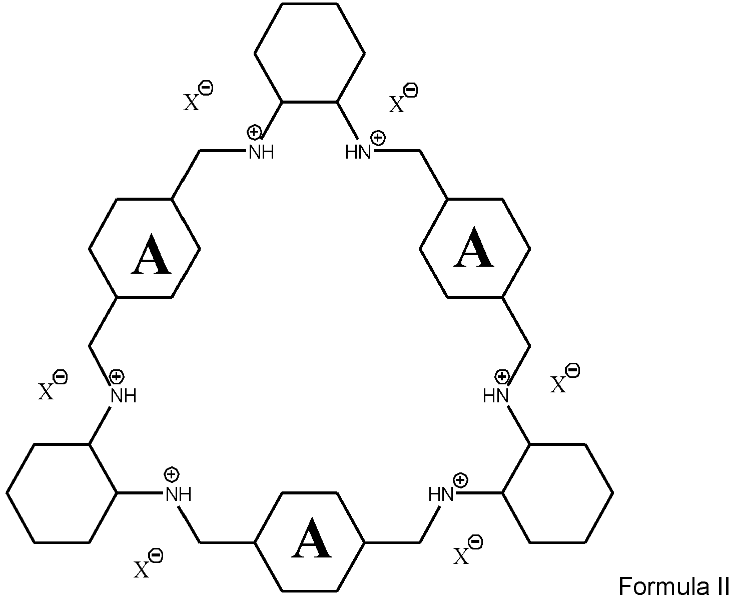 wherein,
- A is defined as above,
- X⁻ is a halogen or molecular anion, preferably chosen from iodide, chloride, bromide and tetrafluoroborate.

Advantageously, A may be chosen from a substituted or unsubstituted phenyl, a substituted or unsubstituted biphenyl, a substituted or unsubstituted triphenyl, a substituted or unsubstituted terphenyl, a substituted or unsubstituted diphenyl ether, a substituted or unsubstituted naphthalene, a substituted or unsubstituted phenanthrene, a substituted or unsubstituted anthracene, a substituted or unsubstituted pyridinyl and a substituted or unsubstituted thiophenyl, preferably a substituted or unsubstituted phenyl, biphenyl, pyridinyl or thiophenyl. Advantageously, A may be chosen from a substituted or unsubstituted phenyl, a substituted or unsubstituted biphenyl, a substituted or unsubstituted triphenyl, a substituted or unsubstituted terphenyl, a substituted or unsubstituted diphenyl ether, a substituted or unsubstituted naphthalene, a substituted or unsubstituted phenanthrene, a substituted or unsubstituted anthracene and a substituted or unsubstituted pyridinyl, preferably a substituted or unsubstituted phenyl. A may be substituted by at least one group chosen from a halo group (preferably F, Br or I), -R⁴ in which R⁴ is a C₁ to C₄ alkyl chain (preferably - Me), -OR⁴ in which R⁴ is a C₁ to C₄ alkyl chain (preferably -OMe), -OH, -NO₂ and -NH₂. Preferably, A may be chosen from the linkers shown in the table 1 below:

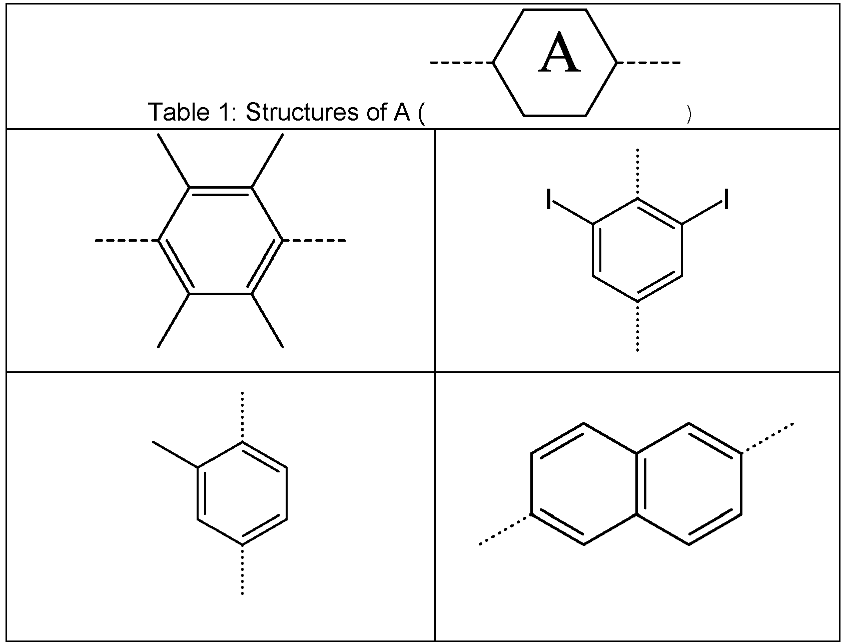

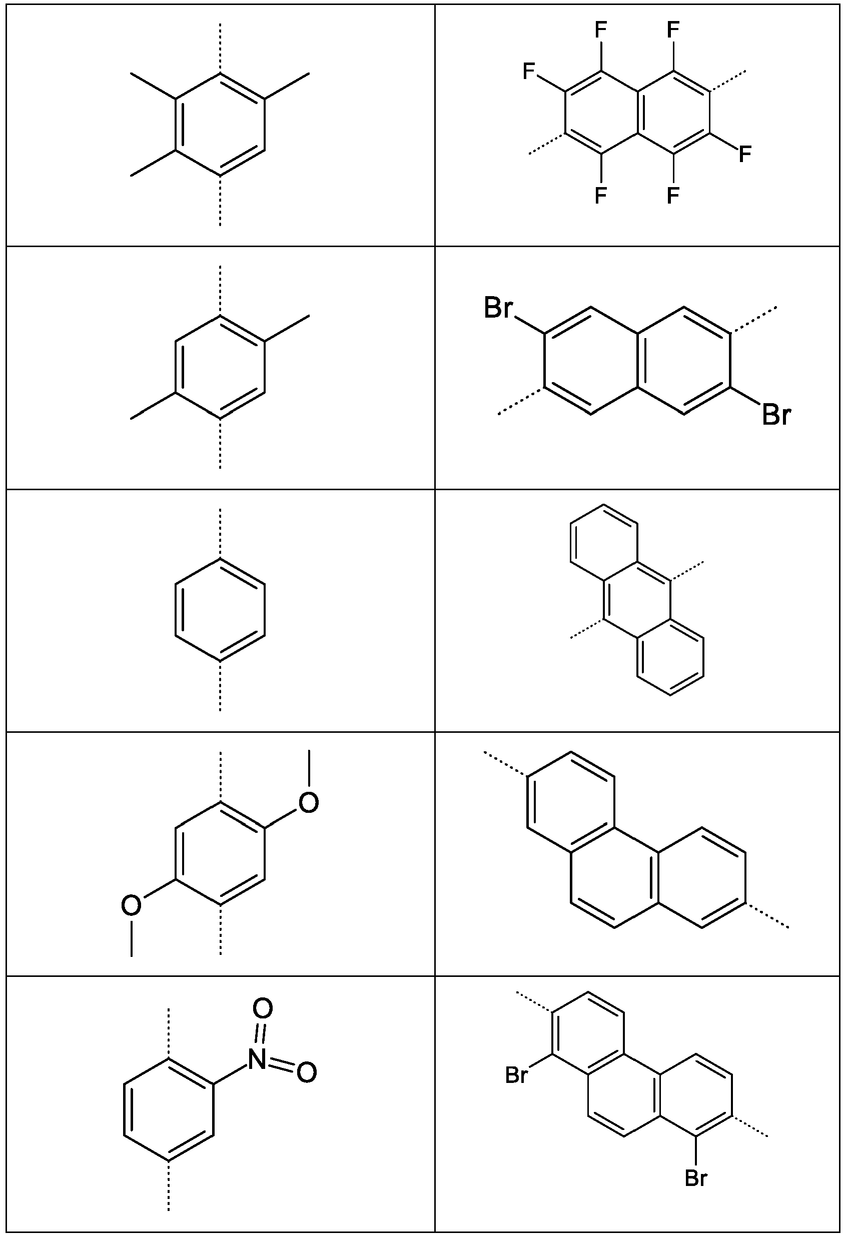

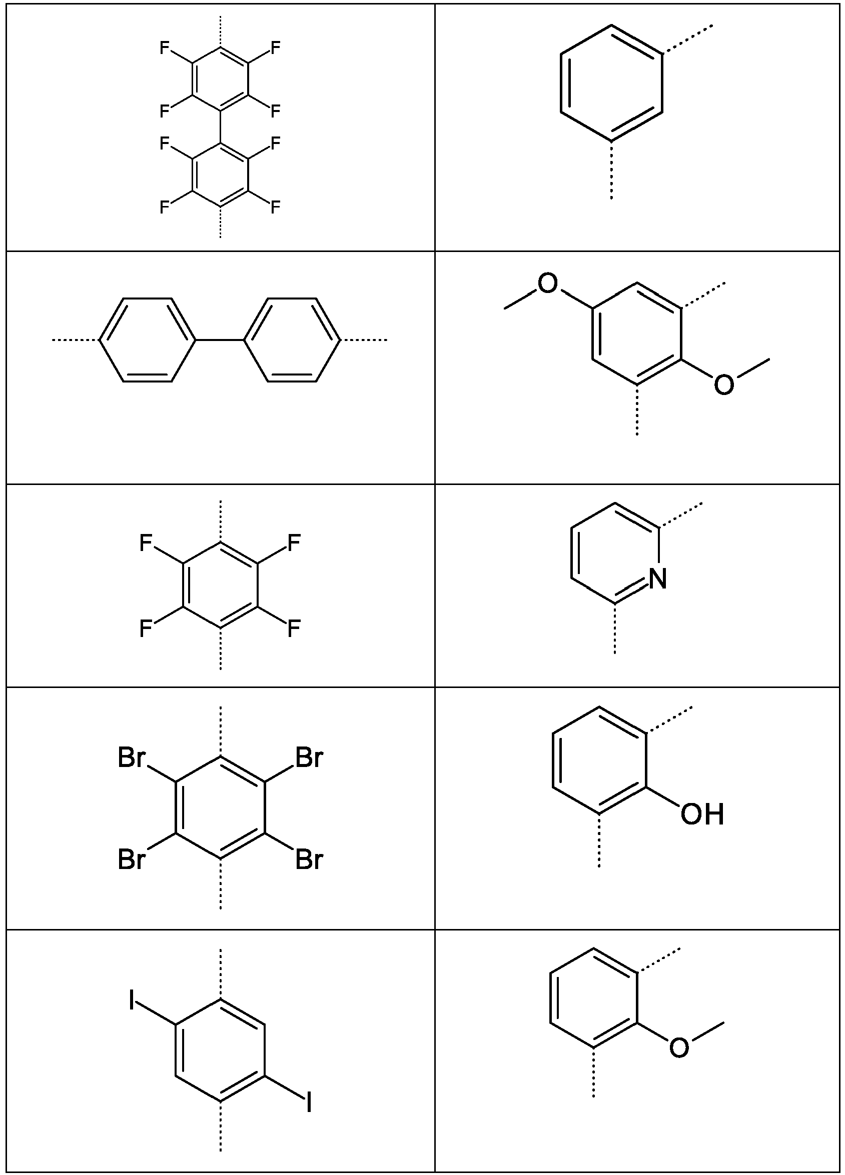

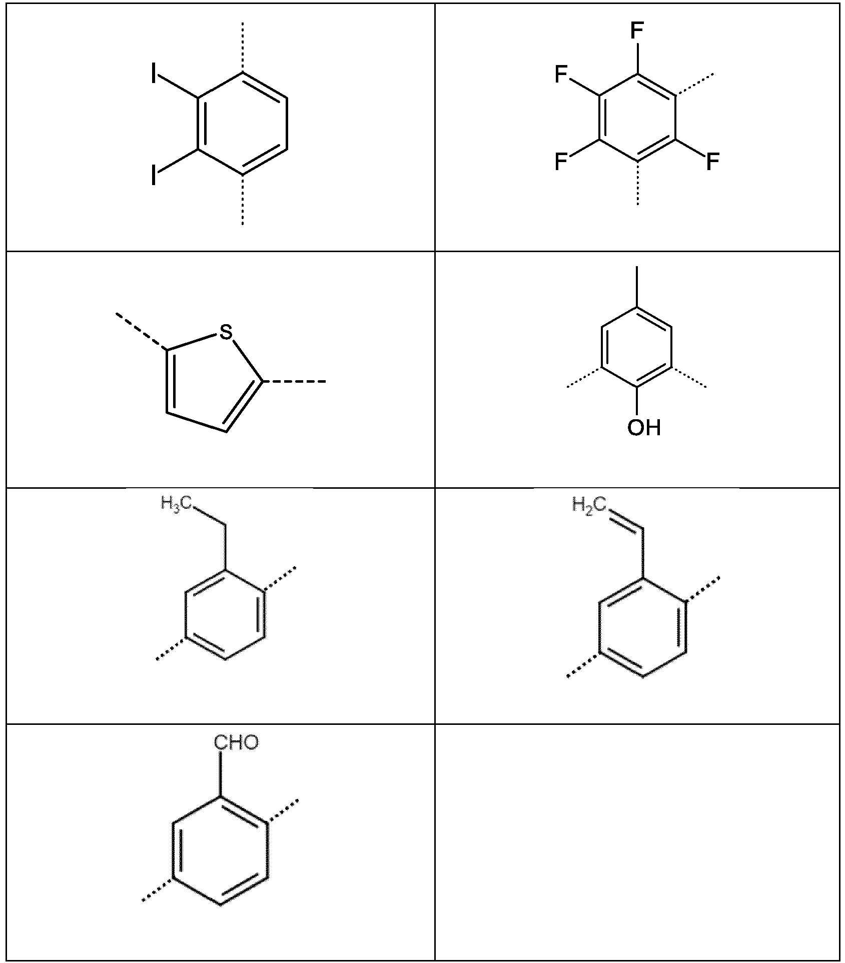

Advantageously, A may be chosen from the linkers shown in the table 2 below:

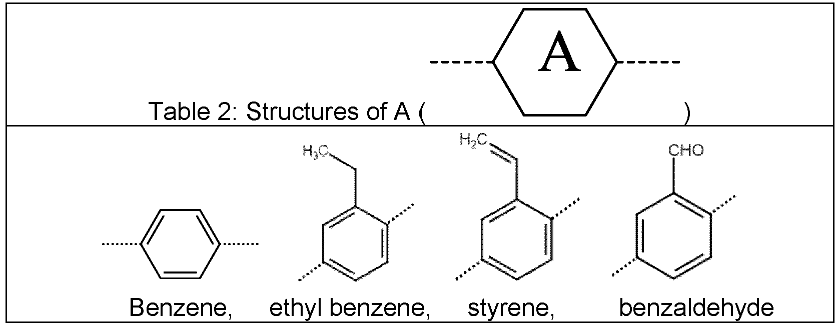

Advantageously, the perovskite according to the invention may be of formula A:

TAₓFA_{y}Cs_{0.15}PbX₃ Formula A

wherein,
- x is from 0.010 to 0.050,
- y is from 0.80 to 0.84,
- x + y = 0.85
- TA is an ion of the trianglamine compound of formula I,
- FA is formamidinium,
- X is halogen or molecular anion, preferably chosen from I, Br, Cl and BF₄.

On another aspect, the invention also relates to the use of a trianglamine salt of formula II: 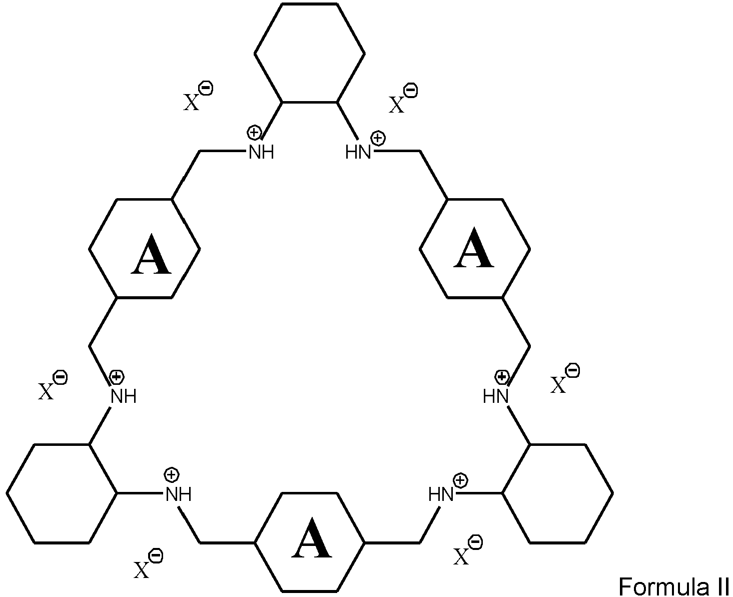 wherein,
- A is defined as above,
- X⁻ is a halogen or molecular anion, preferably chosen from iodide, chloride, bromide and tetrafluoroborate,
as an adduct in a perovskite.

The invention also encompasses a process of synthesis of a perovskite according to the invention according to the invention, comprising the steps of:
a) dissolving a trianglamine salt of formula II: 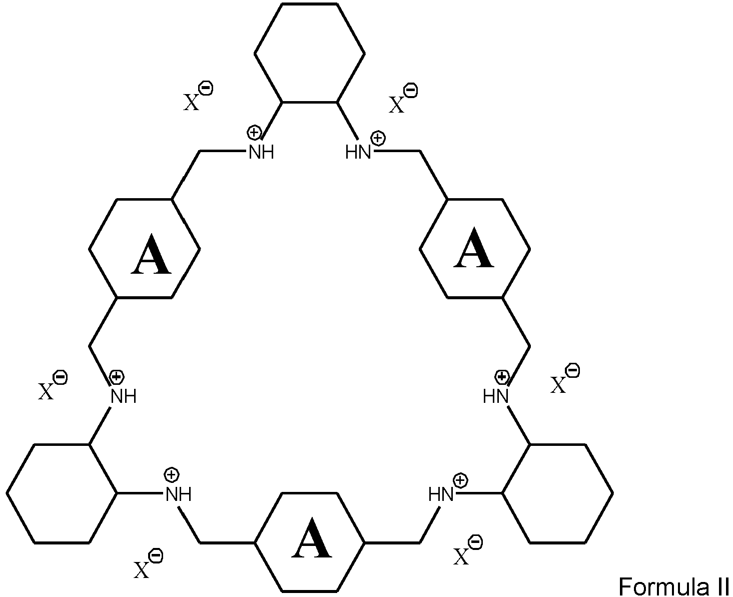 wherein,
   - A is defined as above,
   - X⁻ is defined as above,
      in a solvent in presence of the perovskite precursors, the precursors being preferably FAI, PbI₂ and Csl,
         b) filtering the solution obtained in step a),
         c) spin-coating the filtered solution obtained in step b) on a substrate
         d) annealing the spin-coated substrate obtained in step c), preferably
      including a first annealing period of 10 minutes at 100°C, followed by a second annealing period of 30 minutes at 150°C.

Advantageously, the solvent is an organic solvent chosen from dimethylformamide, dimethylsulfoxide, and mixtures thereof, preferably a mixture DMF:DMSO volumetric ratio 4:1.

Advantageously, the step a) of reacting a trianglamine salt of formula II and the precursors is done at a temperature from 50 to 60°C, preferably 60°C.

Advantageously, step a) has a duration of 12 to 15 hours.

Advantageously, the filtration step b) may be done in a syringe filter, preferably in a polytetrafluoroethylene (PTFE) syringe filter with 0.45-micron pore size.

Advantageously, the substrate in step c) may be chosen from a microscopic glass substrate with indium tin oxide or fluorine-doped tin oxide coating.

Advantageously, step c) is a two-step spin-coating process where the first step involves spin-coating at 1000 rpm for 10 seconds, followed by a second step at 5000 rpm for 30 seconds. During the second step, an antisolvent may be used to induce rapid crystallization. The antisolvent may be chosen from chlorobenzene, toluene, diethyl ether and mixtures thereof.

On another aspect, the invention relates to the use of a trianglamine of formula II as adduct to improve the opto-electronic performance and the properties of HOIPs and FIPs for applications in photovoltaics, photodetectors, LEDs, X-ray detection, transistors and other optoelectronic devices.

The invention relates to a device comprising the perovskite according to the invention, the device preferably being chosen from photovoltaic devices, photodetectors, LEDs, X-ray detection devices, transistors.

### Brief description of the figures

Figure 1a shows PL spectra of control and Target thinfilms before and after hydration for 40 hours.
Figure 1b) shows the evolution of optoelectronically inactive δ-FAPbl3 Phase under 85% static humidity.

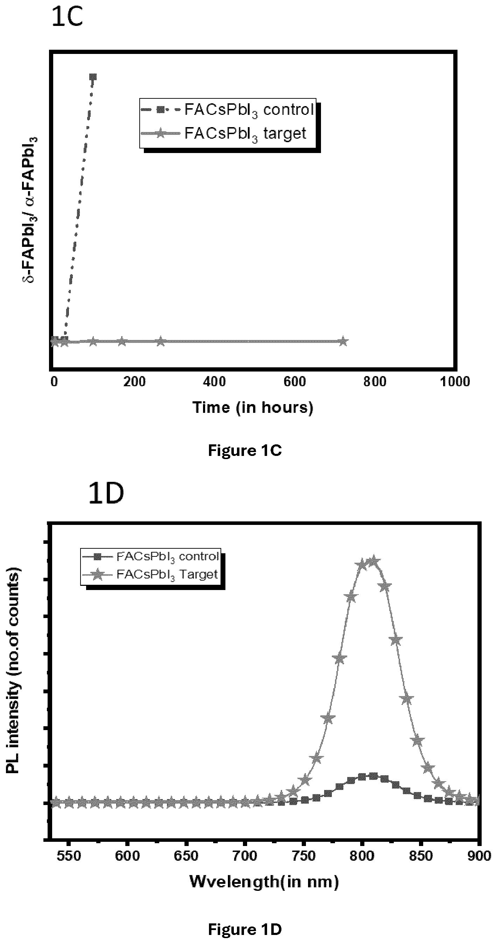

Figure 1c) shows the evolution of optoelectronically inactive δ-FAPbl3 phase under 1 sun (100 mW2) light illumination and 110 °C temperature.
Figure 1d) shows the photoluminescence spectra after 200 hours of 1 sun (100 mW2) light illumination and 110°C temperature..

### EXAMPLES

### Example 1: Preparation of substituted trianglamine iodine (TAI) - containing perovskites

To make a 1.5 M stoichiometric solution of TAₓFA_{y}Cs_{0.15}PbI₃. The precursors FAI, PbI₂, Csl and TAI (wherein A is 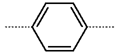 ) are mixed in a single glass veil. Then solution of DMF:DMSO 4:1 is mixed with the precursors.
wherein,
- x is 0.030,
- y is 0.082,
- x + y = 0.85.

The solution is placed on hotplate at 60°C overnight for complete dissolution of the precursors. After that the solution is filtered with 0.40µm PTFE filter. The filtered solution is spin coated on onto the indium tin oxide (ITO) coated glass substrate with 1mm thickness using a two-step spin-coating process where the first step involves spin- coating at 1000 rpm for 10 seconds to ensure even spreading of the precursor, followed by a second step at 5000 rpm for 30 seconds to create a uniform film thickness.

During the high-speed step, 150 µl chlorobenzene was used as an antisolvent to induce rapid crystallization. To obtain the black perovskite α-phase of TAIₓFA_{y}Cs_{0.15}PbI₃, which is essential for efficient photovoltaic performance, increased the annealing temperature to 100°C for 10 minutes and then at 150°C for 30 minutes. The annealing duration is carefully optimized to stabilize the α-phase while avoiding the formation of the undesirable yellow δ-phase, which has poor optoelectronic properties. The resulting film exhibited enhanced crystallinity and phase purity, both of which are critical for improving the open-circuit voltage and short-circuit current density of the perovskite solar cells.

The X-ray diffraction partners and the photoluminscence spectra of TAIₓFA_{y}Cs_{0.15}PbI₃ is compared to that of TAFA _{0.85}Cs_{0.15}PbI₃ and A _{0.85}Cs_{0.15}PbI₃ in Figure 1 (a) and (b).

### Example 2: Improved stability from substituted trianglamine iodine (TAI) - containing perovskites

A bulk layer passivation technique was done on a perovskite thin films as prepared as in example 1, at 110°C and under 1 sun continuous illumination. As seen in Figure 1 (c) The evolution of the optoelectronically inactive δ-FAPbI3 phase with respect to optoelectronically active α-FAPbI3 is plotted and it's clear that under that control films undergo fast degradation at elevated temperature but the robust films with modification survive extremely high temperatures fo PV devices in on field conditions. The photoluminescence spectra after 200 hours of thermal and photostability measurements is still stable in case of Targeted thin films as shown in Figure 1 (d). This can conclude that there are no shallow trap defects generated because of continuous heat.

### List of references

[1] WO2022/058961.

## Claims

1. A perovskite comprising a halogen or molecular anion salt of the trianglamine (TA) compound of formula I: 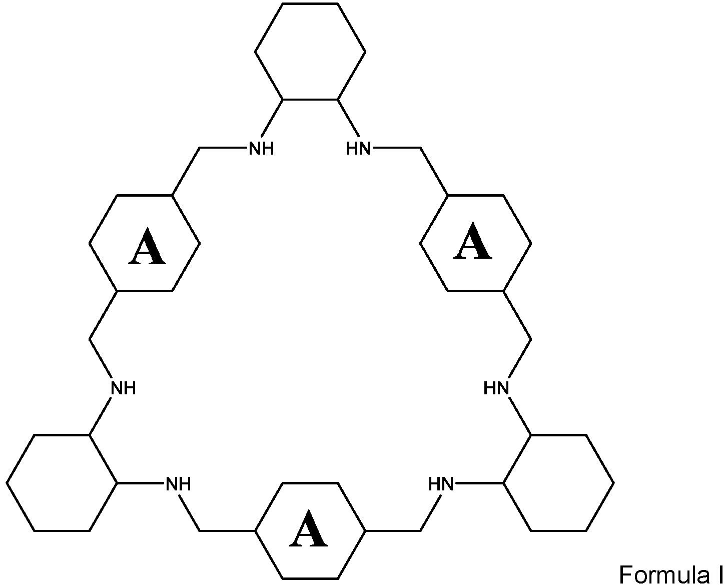 wherein,
- each A independently represents a substituted or unsubstituted 4 to 18-membered aryl or heteroaryl linker, preferably the halogen or molecular anion salt is of formula (TAX*), wherein X*= Xₙ+X⁻ₙ₋₁ wherein n ≤ 6 and X is chosen from Br, Cl, I or BF₄.

2. The perovskite according to claim 1, comprising a trianglamine salt of formula II: 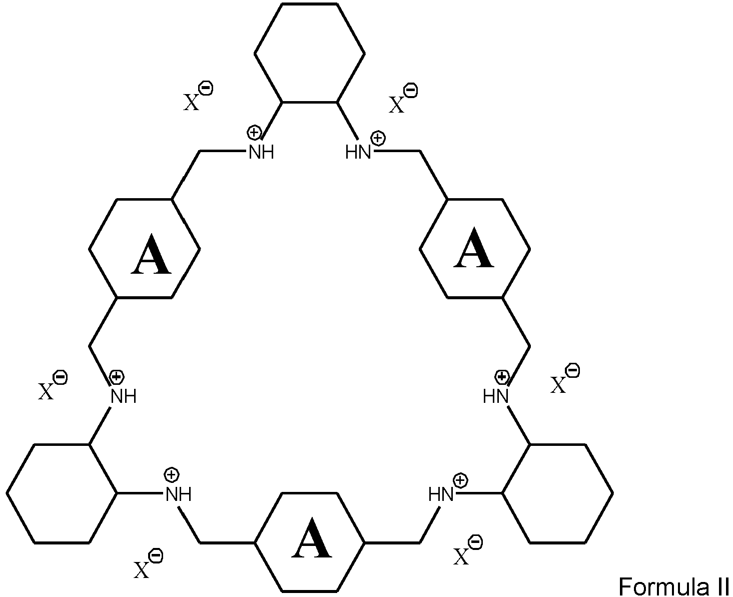 wherein,
- A is defined as in claim 1,
- X⁻ is a halogen or molecular anion, preferably chosen from iodide, chloride, bromide and tetrafluoroborate.

3. The perovskite according to claim 1 or 2, wherein A is chosen from a substituted or unsubstituted phenyl, a substituted or unsubstituted biphenyl, a substituted or unsubstituted triphenyl, a substituted or unsubstituted terphenyl, a substituted or unsubstituted diphenyl ether, a substituted or unsubstituted naphthalene, a substituted or unsubstituted phenanthrene, a substituted or unsubstituted anthracene, a substituted or unsubstituted pyridinyl and a substituted or unsubstituted thiophenyl, preferably a substituted or unsubstituted phenyl, biphenyl, pyridinyl or thiophenyl.

4. The perovskite according to any of preceding claims, wherein A is chosen from:

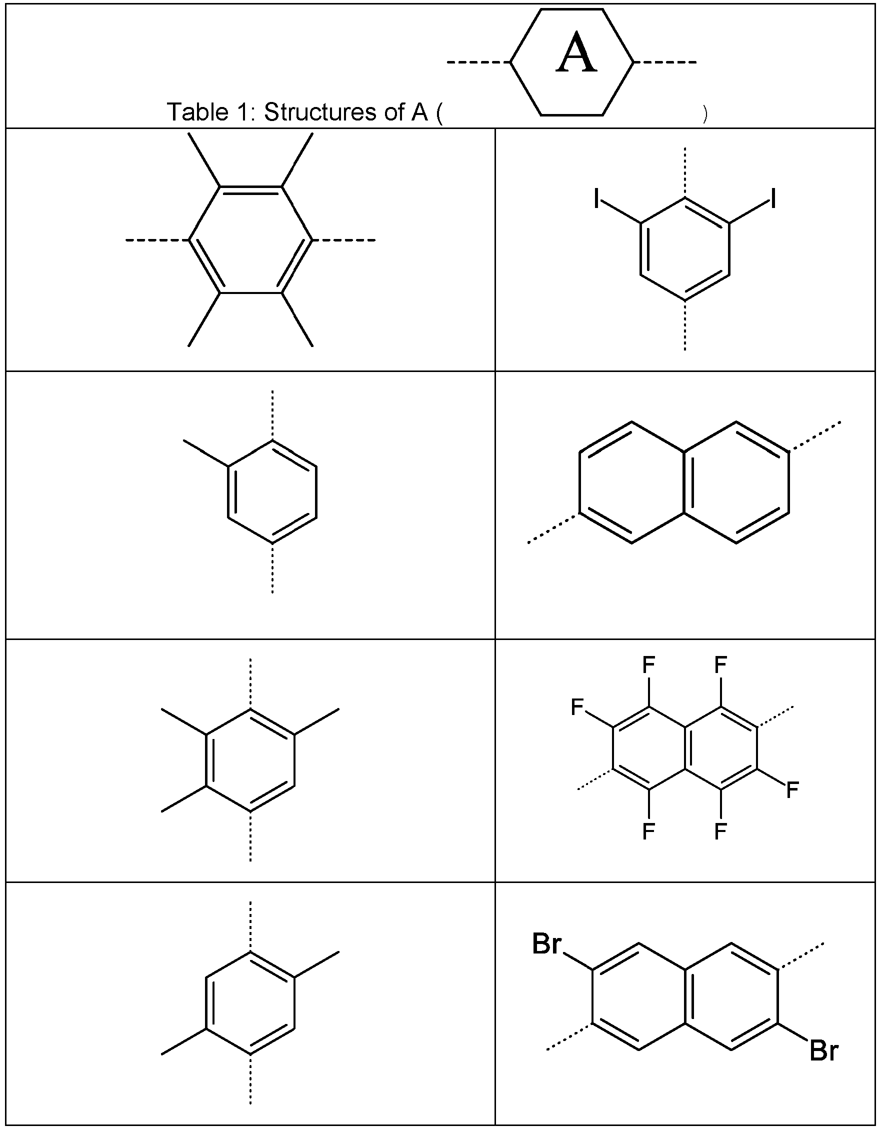

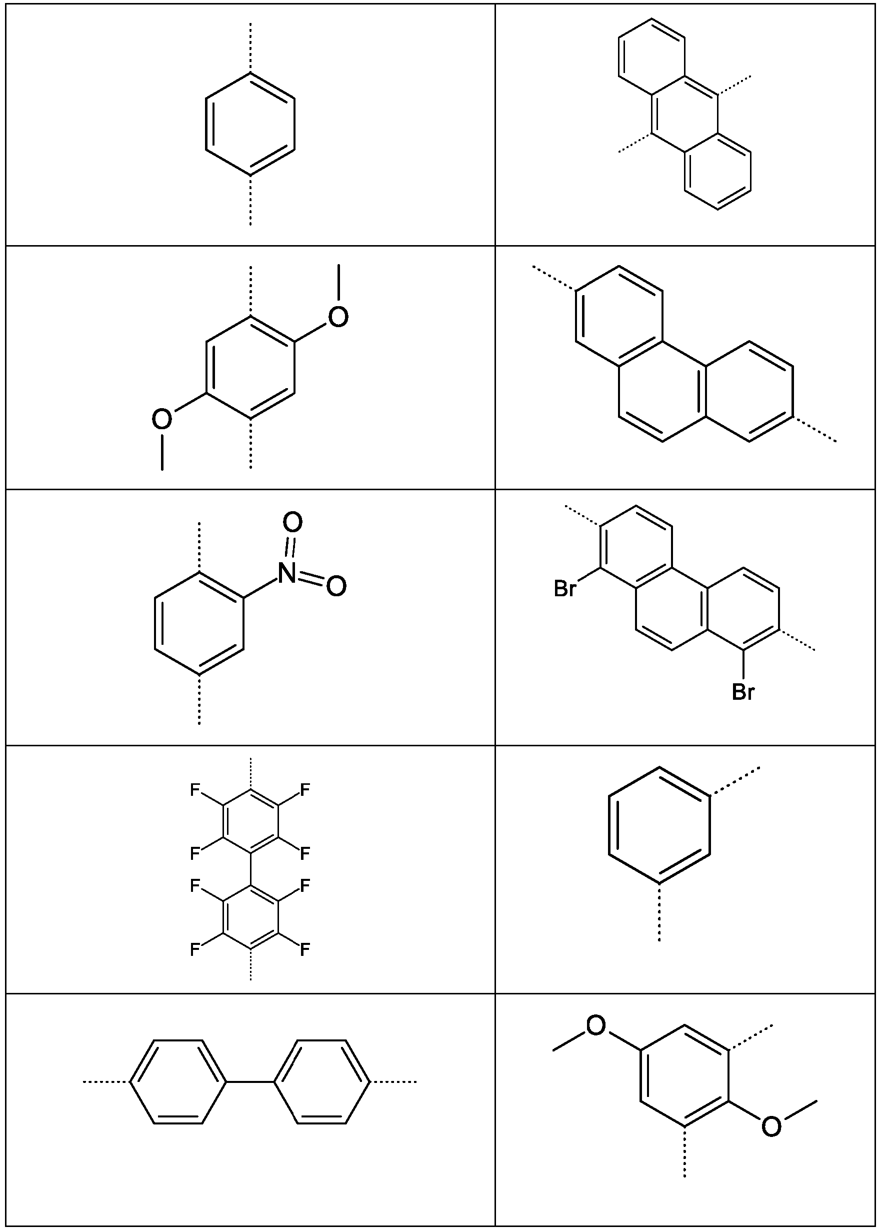

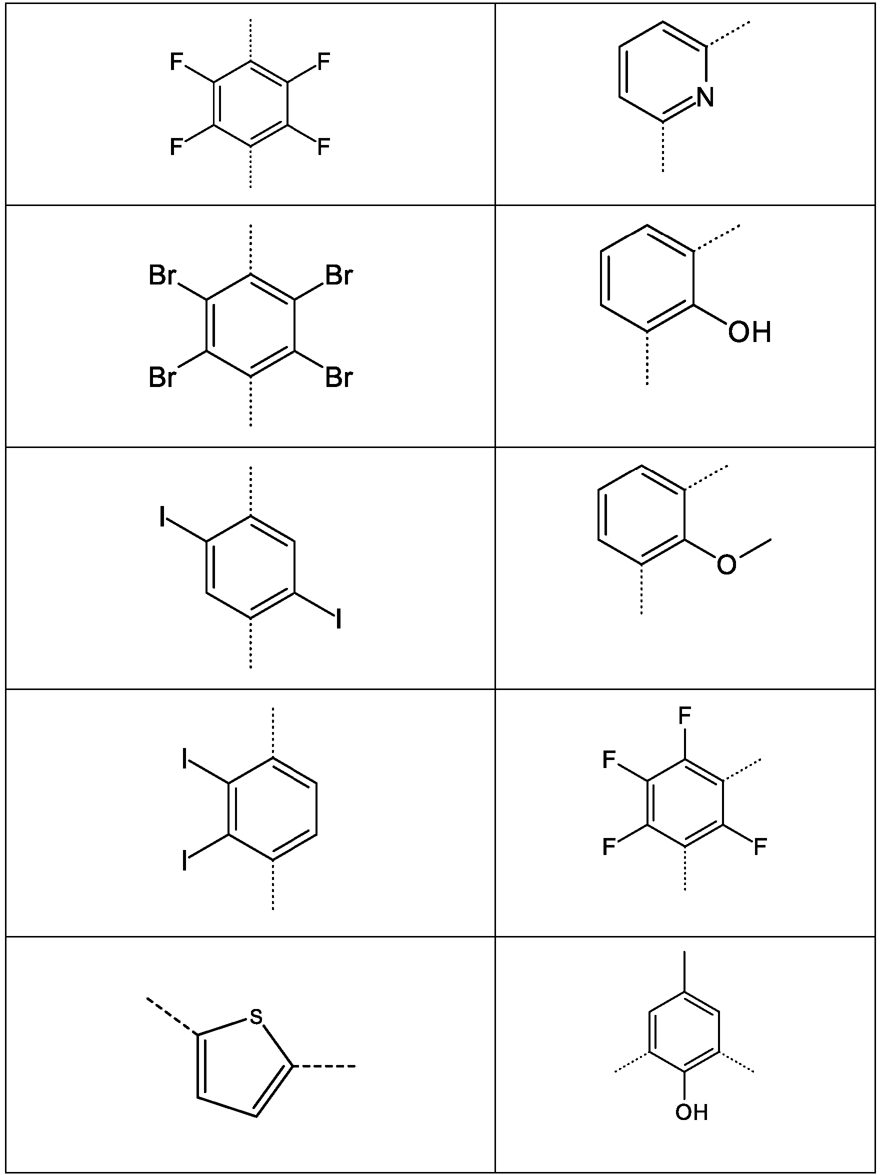

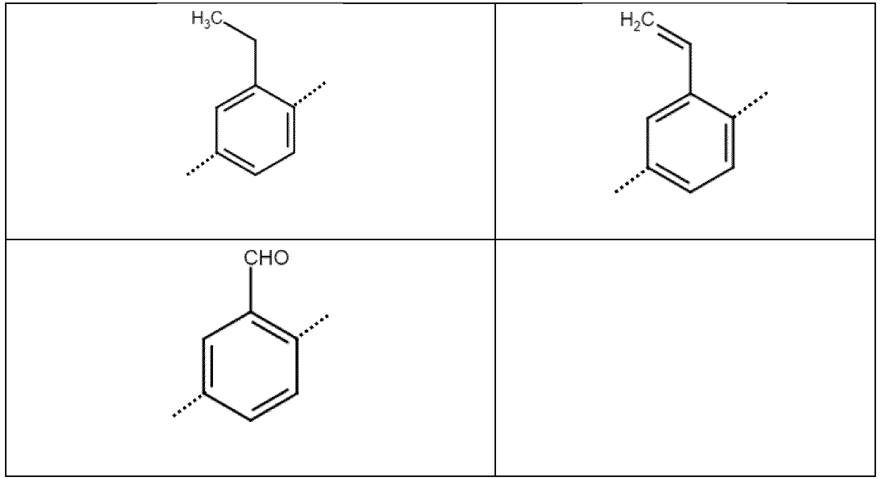

5. The perovskite according to any of preceding claims, wherein the perovskite is of formula A:
TAₓFA_{y}Cs_{0.15}PbI₃ Formula A
wherein,
- x is from 0.010 to 0.050,
- y is from 0.80 to 0.84,
- x + y = 0.85
- TA is an ion of the trianglamine compound of formula I,
- FA is formamidinium,
- X is halogen or molecular anion, preferably chosen from I, Br, Cl and BF₄.

6. The use of a trianglamine halogen or molecular anion substituted salt of formula II: 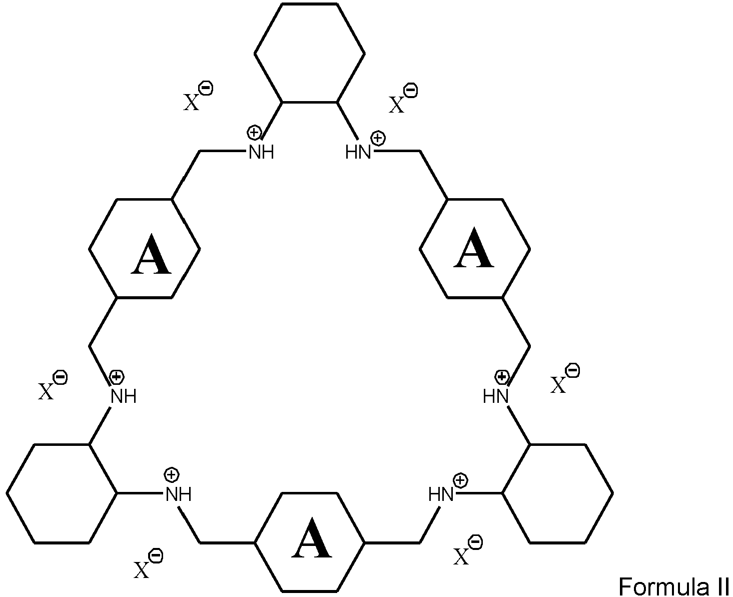 wherein,
- A is defined as in preceding claims,
- X⁻ is a halogen or molecular anion, preferably chosen from iodide, chloride, bromide and tetrafluoroborate,
as an adduct in a perovskite.

7. A process of synthesis of a perovskite according to claim 1 to 6, comprising the steps of:
a) dissolving a trianglamine salt of formula II: 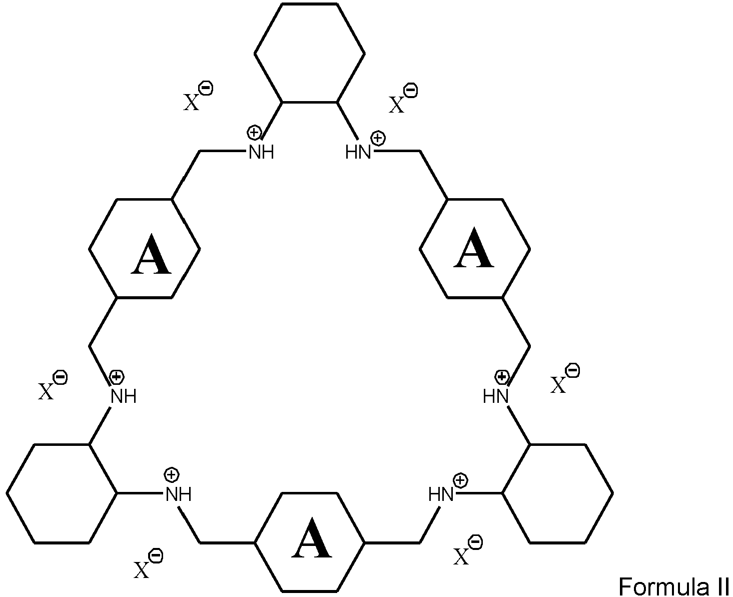 wherein,
- A is defined as in preceding claims,
- X⁻ is defined as in preceding claims,
in a solvent in presence of the perovskite precursors, the precursors being preferably FAI, PbI2, Csl,
b) filtering the solution obtained in step a),
c) spin-coating the filtered solution obtained in step b) on a substrate
d) annealing the spin-coated substrate obtained in step c), preferably including a first annealing period of 10 minutes at 100°C, followed by a second annealing period of 30 minutes at 150°C.

8. A device comprising the perovskite according to claim 1 to 6, the device preferably being chosen from photovoltaic devices, photodetectors, LEDs, X-ray detection devices, transistors.
